# EUROPÄISCHE PATENTSCHRIFT

(11) **EP 0 655 513 B1**
(45) Veröffentlichungstag und Bekanntmachung des Hinweises auf die Patenterteilung: **22.10.1997**
(21) Anmeldenummer: 94104276.4
(22) Anmeldetag: 18.03.1994
(51) Int. Cl.: C23C 14/56, C23C 16/54, H01L 21/00

(54) **Vorrichtung und Verfahren zum schrittweisen und automatischen Be- und Entladen einer Beschichtungsanlage**
Apparatus and method for stepwise and automatic loading and unloading of a coating apparatus
Appareil et procédé pour charger et décharger, automatiquement par reprises successives, un dispositif de revêtement

(30) Priorität: 29.11.1993 DE 4340522
(43) Veröffentlichungstag der Anmeldung: 31.05.1995
(73) Patentinhaber: Balzers und Leybold Deutschland Holding Aktiengesellschaft, 63450 Hanau (DE)
(72) Erfinder: Kempf, Stefan, Dipl.-Ing., D-63755 Alzenau (DE)

(56) Entgegenhaltungen:
- EP-A- 0 312 694
- EP-A- 0 354 294
- US-A- 5 217 501

## Beschreibung

Die Erfindung betrifft eine Vorrichtung und ein Verfahren zum schrittweisen und automatischen Be- und Entladen einer Beschichtungsanlage mit scheibenförmigen Substraten, insbesondere für die Datenspeichertechnik. Diese Vorrichtung besteht im wesentlichen aus einem Magazin mit einem ersten Drehteller, auf dem eine Vielzahl von Haltedornen zur Aufnahme der Substrate angeordnet sind.

Die zu beschichtenden Substrate werden mittels einer Übergabeeinrichtung einzeln in die Beschichtungszone einer Vakuumkammer eingeschleust und nach dem Beschichten wieder mittels der Übergabeeinrichtung auf einen Haltedorn des Magazins zurückgelegt.

Die Arbeitsweise einer solchen Vorrichtung kann wegen des Stillstandes zwischen den einzelnen Schritten, bedingt durch die Ein- und Ausschleusvorgänge, sowie durch den stationären Beschichtungsvorgang als quasi-kontinuierlich bezeichnet werden.

Bekannt ist beispielsweise eine Vorrichtung nach dem Karussell-Prinzip zum Beschichten von Substraten (EP 0 312 694). Hierbei ist in einer Vakuumkammer ein drehbarer Substrathalter angeordnet, auf dem mehrere Substrataufnahmen vorgesehen sind. Durch einen Antrieb ist eine entsprechende Anzahl von Substraten schrittweise auf einer Kreisbahn von einer Schleusenstation über mindestens eine Beschichtungsstation zur Schleusenstation transportierbar. Diese Vakuumkammer besitzt in Umfangsrichtung des drehbaren Substrathalters zwei Schleusenstationen und zwei Beschichtungsstationen jeweils hintereinander. Die Schrittweite des Antriebs einerseits und die Winkelstellung jeder Beschichtungsstation zu der ihr zugeordneten Schleusenstation in Bezug auf die Drehachse des Substrathalters andererseits sind so gewählt, daß ein und dieselbe Beschichtungsstation über die schrittweise Bewegung jeweils einer bestimmten Substrataufnahme und derselben Schleusenstation zugeordnet ist.

Beim Betrieb derartiger Vorrichtungen sind die sogenannten Beladestationen von Bedeutung, mit denen eine automatische Be- und Entladung solcher Vorrichtungen möglich ist. Derartige Beladestationen sind in Verbindung mit den zugehörigen Magazinen verhältnismäßig aufwendig und ihre Taktfrequenz ist für den wirtschaftlichen Betrieb der Beschichtungsanlage, beispielsweise zur Herstellung von Compact-Discs, im folgenden CD genannt, von größter wirtschaftlicher Bedeutung.

Im Stand der Technik sind daher einerseits solche Be- und Entladevorrichtungen bekannt, die Substratmagazine mit zwei Drehtellern vorsehen und welche daher einen großen Raumbedarf erforderlichen machen.

Andererseits besteht ein Problem darin, daß die Transportarme der Übergabeeinrichtung ein Substrat von einem Magazin aufnehmen und der Beschichtungsanlage übergeben und gleichzeitig ein zweiter Transportarm ein Substrat von der Beschichtungsanlage auf ein anderes Magazin zurücklegt. Dabei können diese beiden Transportarme jeweils nur zwei Stationen, nämlich eine Be- und eine Entladestation der Magazine bedienen. Sobald alle Substrate von dem Haltedorn, welcher sich gerade auf der Beladestation befindet, entnommen sind, wird der Drehteller üblicherweise um eine Station weitergedreht, so daß der entladene Haltedorn nun von Hand entnommen und auf der Entladestation des anderen Drehtellers abgesetzt wird. Anschließend wird dieser Haltedorn wieder mit Substraten beladen, welche von der Beschichtungsanlage zurückkehren.

Da auf ein und derselben Beschichtungsanlage nicht nur CD's, beispielsweise desselben Musik-Titels behandelt werden, ergibt sich beim Wechsel von einem Titel A auf einen Titel B zwangsweise ein Maschinenleerlauf; sobald die letzte CD, mit dem Titel A von dem Drehteller des Magazins entnommen wurde, wird üblicherweise die Beschichtungsanlage zunächst "leergefahren". Andernfalls werden die von der Beschichtungsanlage zum Magazin zurückkehrenden CD's unterschiedlicher Titel A und B auf ein und demselben Haltedorn abgelegt.

Um diese oben genannten Nachteile zu vermeiden, liegt der Erfindung die Aufgabe zugrunde, eine Vorrichtung der eingangs beschriebenen Gattung dahingehend zu verbessern, daß zum einen ein hoher Durchsatz an zu beschichtenden Substraten bei langer Maschinenlaufzeit ohne Personaleingriff gewährleistet ist, zum anderen ein möglichst geringer Raumbedarf der Gesamtanlage benötigt wird, daß weiterhin die kontinuierliche Behandlung beispielsweise unterschiedlicher CD-Titel ermöglicht wird und daß vor allem die Investitionskosten nicht wesentlich gesteigert werden.

Diese Aufgabe wird erfindungsgemäß gemäß Anspruch 1 dadurch gelöst, daß eine Vorrichtung zum schrittweisen und automatischen Be- und Entladen einer Beschichtungsanlage mit scheibenförmigen Substraten, insbesondere für die Datenspeichertechnik, verwendet wird, welche im wesentlichen aus einem Magazin mit einem ersten Drehteller besteht, der schrittweise um eine ortsfeste Rotationsachse drehbar ist und eine Vielzahl von Haltedornen in äquidistanter Verteilung und in Kreisform auf dem Drehteller angeordnet sind. Dabei sind auf jedem einzelnen Dorn mehrere Substrate stapelbar und für das Magazin sind ortsfeste Belade- und Entlade-Stationen vorgesehen. Diese Vorrichtung besteht weiterhin aus einer Übergabeeinrichtung mit einem zweiten Drehteller, der schrittweise um eine ortsfeste Rotationsachse drehbar ist und der mindestens drei Stationen zur Aufnahme je eines Substrates aufweist; mit mindestens drei Transportarmen, welche mit je einer Station des zweiten Drehtellers korrespondieren, wobei der Beladearm jeweils ein Substrat von dem Dorn aufnimmt, welcher sich gerade auf der Beladestation des Magazins befindet und das Substrat auf der Beladestation der Übergabeeinrichtung ablegt und wobei der Entladearm gleichzeitig ein Substrat von der Entladestation der Übergabeeinrichtung aufnimmt und dieses auf einem von zwei möglichen Haltedornen zurücklegt, welche sich gerade auf den beiden Entladestationen des Magazins befinden. Erfindungswesentlich ist eine Steuereinrichtung, welche insbesondere aus einem Sensor, einem Zählwerk und einem Stellmotor besteht, wobei der Stellmotor den Entladearm antreibt und der zu beladende Dorn des Magazins durch die Steuereinrichtung vorher bestimmbar ist.

Um einen störungsfreien Betrieb zu gewährleisten, sind die beide Drehteller in einer horizontalen Ebene angeordnet, wobei die Haltedorne senkrecht auf dem Drehteller befestigt sind und die Substrate eine zentrische Längsbohrung aufweisen. Mit Vorteil sind die Drehteller nur in einer Drehrichtung jeweils um eine Station schrittweise weiterbewegbar.

Die Transportarme haben eine ortsfeste Schwenkachse, wobei an ihnen Mittel vorgesehen sind, die die Substrate greifen, heben, schwenken oder wenden, senken oder ablegen.

Vorzugsweise ist eine Schwenkbewegung des Belade- und des Übergabearms durch je zwei ortsfeste Endpunkte markiert, wobei die Schwenkachse des Entladearms so angeordnet ist, daß dieser mit seinem beweglichen Ende drei ortsfeste Endpunkte auf den beiden Drehteller erreicht.

Erfindungsgemäß überstreicht der Entladearm einen Schwenkwinkel zwischen Entladestation der Übergabeeinrichtung und der einen Entladestation des Magazins und einen Schwenkwinkel zwischen Entladestation der Übergabeeinrichtung und der anderen Entlade-station des Magazins, wobei der eine Schwenkwinkel größer als der andere ist.

Mit Vorteil sind auf einem Haltedorn des Magazins nur gleichartige Substrate gestapelt, wobei auf verschiedenen anderen Haltedornen des Magazins verschiedene Substrate gestapelt sind.

Zweckmäßigerweise sind die Anzahl der Schwenkbewegungen des Entladearms mit zwei Schwenkwinkeln in einem Zählwerk einer Steuereinrichtung speicherbar, wobei der Entladearm, nachdem der Stellmotor ein zweites elektrisches Signal erhalten hat, den kleineren Schwenkwinkel überstreicht und die folgenden Substrate auf dem Dorn ablegt, welche sich gerade auf der anderen Entladestation des Magazins befindet. Der Entladearm überstreicht dabei bis zum Erhalt eines dritten elektrischen Signals von der Steuereinheit den kleineren Schwenkwinkel, wobei der Stellmotor ein drittes elektrisches Signal von der Steuereinrichtung erhält, nachdem alle Substrate vom Dorn entnommen sind, der sich nun auf der Beladestation des Magazins befindet. Mit Vorteil transportiert der Übergabearm je ein Substrat von der Übergabestation der Übergabeeinrichtung zur Beschichtungsanlage und zurück.

Die oben beschriebene Vorrichtung hat tatsächlich einen wesentlich geringeren Raumbedarf als die herkömmliche Version mit einem Magazin bestehend aus zwei Drehtellern. Der wesentliche Vorteil der hier beschriebenen Erfindung besteht jedoch darin, daß die Vorrichtung mit unterschiedlichen Substraten, beispielsweise CD's der Titel A und B beladen werden kann, und daß diese kontinuierlich durch die Beschichtungsanlage behandelt und wieder zum Magazin zurückgeführt werden können, ohne daß es einer Maschinenleerlaufzeit bedarf und daß die leeren Haltedorne automatisch von der Belade- zur Entladestation transportiert werden.

Erfindungsgemäß findet ein Verfahren zum schrittweisen und automatischen Be- und Entladen einer Beschichtungsanlage mit scheibenförmigen Substraten, insbesondere für die Datenspeichertechnik Anwendung, mittels einer Vorrichtung im wesentlichen bestehend aus einem Magazin mit einem ersten Drehteller, welcher schrittweise um eine ortsfeste Rotationsachse drehbar ist und einer Vielzahl in äquidistanter Verteilung und in Kreisform auf dem Drehteller angeordneten Haltedornen, wobei auf jedem Dorn mehrere Substrate stapelbar sind und für das Magazin ortsfeste Belade- und Entlade-Stationen vorgesehen sind und der Abstand zwischen je zwei benachbarten Stationen dem Abstand zwischen je zwei benachbarten Haltedornen entspricht, einer Übergabeeinrichtung mit einem zweiten Drehteller, der schrittweise um eine ortsfeste Rotationsachse drehbar ist und der mindestens drei Stationen - eine Belade-, eine Übergabe- und eine Entlade-Station - zur Aufnahme je eines Substrates aufweist, mit mindestens drei Transportarmen, einem Belade-, einem Übergabe- und einem Entladearm, welche mit je einer Station des zweiten Drehtellers korrespondieren, wobei der Beladearm jeweils ein Substrat von dem Dorn aufnimmt, welcher sich gerade auf der Beladestation des Magazins befindet und das Substrat auf der Beladestation der Übergabeeinrichtung ablegt und der Entladearm gleichzeitig ein Substrat von der Entlade-station der Übergabeeinrichtung aufnimmt und dieses auf einen von zwei möglichen Haltedornen zurücklegt, welche sich gerade auf den beiden Entladestationen des Magazins befinden und einer Steuereinrichtung, welche insbesondere aus einem Sensor, einem Zählwerk und einem Stellmotor besteht, wobei der Stellmotor den Entladearm antreibt und der zu beladende Dorn des Magazins durch die Steuereinrichtung vorherbestimmbar ist.

Die Erfindung läßt die verschiedensten Ausführungsmöglichkeiten zu; eine davon ist beispielhaft in den anhängenden Zeichnungen schematisch dargestellt, und zwar zeigen:
- Figur 1: die erfindungsgemäße Vorrichtung in der Draufsicht und in schematischer Darstellung,
- Figur 2: ein Detail aus Figur 1, insbesondere die Entladestation, in vergrößerter Darstellung und
- Figuren 3A bis 3I: einen Be- und Entladevorgang mit verschiedenen Substraten A und B in sequentieller Darstellung.

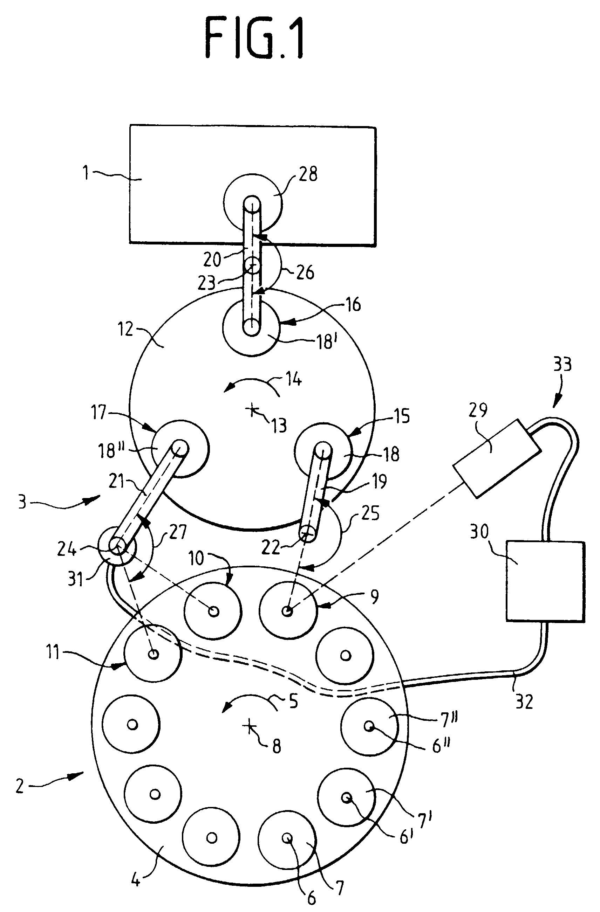

Die erfindungsgemäße Vorrichtung (Figur 1) ist in drei wesentliche Baugruppen unterteilbar; die Beschichtungsanlage 1, das Magazin 2 und die Übergabeeinrichtung 3. Das Magazin 2 besteht aus einem kreisscheibenförmigen Drehteller 4, welcher um die Rotationsachse 8 in Drehrichtung 5 bewegbar ist. Auf dem Drehteller sind mehrere Haltedorne 6, 6', ... vorgesehen, welche in Kreisform und in gleichen Abständen zueinander angeordnet sind. Die Hauptachsen dieser Haltedorne 6, 6', ... sind dabei lotrecht auf der Oberfläche des Drehtellers 4 ausgerichtet. Die zu behandelnden kreisscheibenförmigen Substrate 7, 7', ... weisen eine zentrische Bohrung auf und sind somit in Gruppen zu jeweils mehreren Substraten auf einem Haltedorn 6,6',... gestapelt.

An der Stelle, an welcher das Magazin 2 der Übergabeeinrichtung 3 am nächsten zugeordnet ist, sind für das Magazin 2 ortsfeste Stationen eingerichtet. Dies ist eine Belade-Station 9, eine erste Entlade-Station 10 und eine zweite Entlade-Station 11. Die Abstände zwischen zwei benachbarten Stationen entsprechen dabei gerade dem Abstand zwischen benachbarten Haltedornen 6, 6', .... Durch die schrittweise Drehbewegung des Tellers 4 ist somit jeder Haltedorn 6, 6', ... über die drei ortsfesten Stationen 9, 10 und 11 hinweg bewegbar.

Die Übergabeeinrichtung 3 besteht im wesentlichen aus einem Drehteller 12, welcher um die Rotationsachse 13 in Drehrichtung 14 bewegt wird. Auf dem Drehteller 12 sind, im Gegensatz zum Drehteller 4 des Magazins 2, drei äquidistante Ausnehmungen vorgesehen, welche sich mit dem Drehteller 12 um die Achse 13 bewegen. Diese werden als Belade-Station 15, als Übergabe-Station 16 und als Entlade-Station 17 bezeichnet. Die Begriffe Beladen und Entladen beziehen sich jeweils auf die Beschichtungsanlage 1.

Der Weg eines Substrates 7, 7', ... von dem Magazin 2 zur Beschichtungsanlage 1 und wieder zurück zum Magazin 2 ist nun der folgende: Ein Substrat wird mittels des Transportarms 19 von der Belade-Station 9 des Magazins 2 aufgenommen und zur Übergabeeinrichtung 3 transportiert und dort auf der Beladestation 15 abgelegt. Durch Drehung des Tellers 12 wird das Substrat 18 zur Übergabestation 16 weitertransportiert. Von dort nimmt ein Transportarm 20 das Substrat 18' und legt es in der Beschichtungsanlage 1 ab. Das Substrat 28 wird nun über mehrere Stationen, die der Einfachheit halber nicht dargestellt sind, innerhalb der Beschichtungsanlage 1 weiterbefördert. Das beschichtete Substrat wird anschließend wieder von dem Transportarm 20 aufgenommen und zur Übergabestation 16 zurückgelegt. Durch schrittweise Drehung des Tellers 12 in Drehrichtung 14 wird das Substrat nun zur Entlade-Station 17 der Übergabeeinrichtung 3 weiter transportiert. Dort übernimmt ein Transportarm 21 das Substrat 18" und legt es anschließend auf einem der beiden Haltedorne des Magazins 2 ab, welche sich gerade auf den Entlade-Stationen 10, bzw. 11 befinden. Das Entladen des Magazins 2, genauso wie natürlich das Beladen, wird von einer weiteren Vorrichtung oder auch durch Bedienpersonal durchgeführt.

Der Beladearm 19 ist an seinem einen Ende um die Schwenkachse 22 drehbar gelagert und führt eine Schwenkbewegung 25 im Bereich des bogenförmigen Pfeils aus. Der Übergabearm 20 ist mittig in der Schwenkachse 23 gelagert und führt eine Schwenkbewegung 26 um 180 Grad aus. Der Entladearm 21 besitzt an seinem einen Ende eine Schwenkachse 24, um welche er eine Schwenkbewegung 27 innerhalb des kreisbogenförmigen Pfeils ausführt.

Eine Steuereinrichtung 33 besteht aus einem, beispielsweise optischen Sensor 29, welcher auf den Haltedorn der Belade-Station 9 des Magazins 2 ausgerichtet ist. Dieser Sensor 29 registriert, wenn alle Substrate 6, 6', ... von diesem Dorn entnommen sind, bzw. wenn ein mit Substraten 7, 7', ... beladener Haltedorn an der Beladeposition 9 angekommen ist. Die Signale des Sensors 29 werden in ein Zählwerk 30 geleitet und von dort über ein Steuerkabel 32 an den Stellmotor 31 übermittelt. Der Stellmotor 31 ist zum Antrieb des Entladearms 21 der Übergabeeinrichtung 3 vorgesehen.

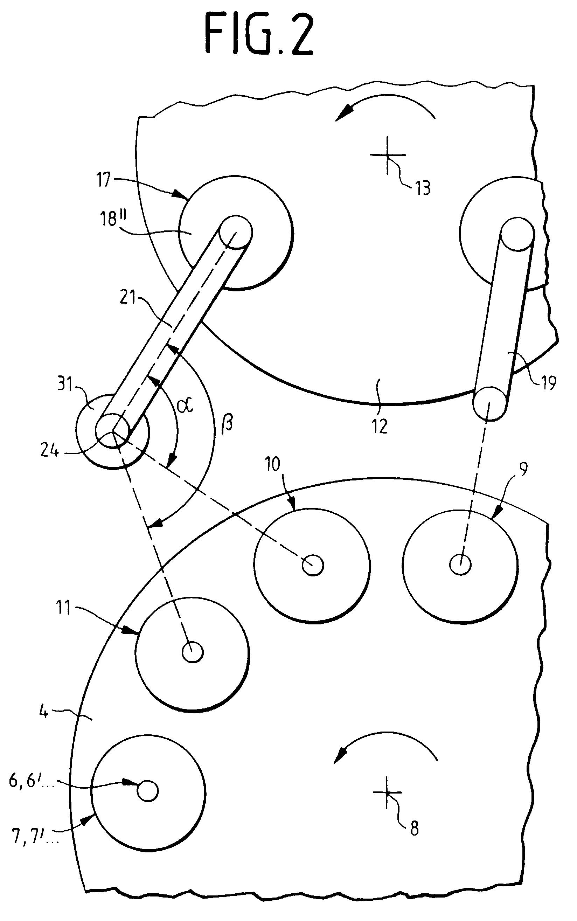

Der Entladearm 21 (Figur 2) ist an seinem einen Ende um die Schwenkachse 24 drehbar gelagert. Für das andere Ende des Entladearms 21 sind drei ortsfeste Haltepunkte vorgesehen; dies ist zum einen die Entladestation 17 auf dem Drehteller 12 der Übergabeeinrichtung 3, zum anderen die Entlade-Station 10 sowie die Entladestation 11 des Magazins 2. Verbindet man die Schwenkachse 24 mit den jeweiligen Haltepunkten 17, 10 und 11, so ergeben sich drei strahlenförmig zueinander angeordnete Linien. Zwischen den Haltepunkten 17 und 10 ergibt sich somit ein Schwenkwinkel a, welcher rein zufällig in etwa einem rechten Winkel entspricht. Zwischen den Haltepunkten 17 und 11 wird ein Schwenkwinkel β definiert, welcher größer ist als der Schwenkwinkel α.

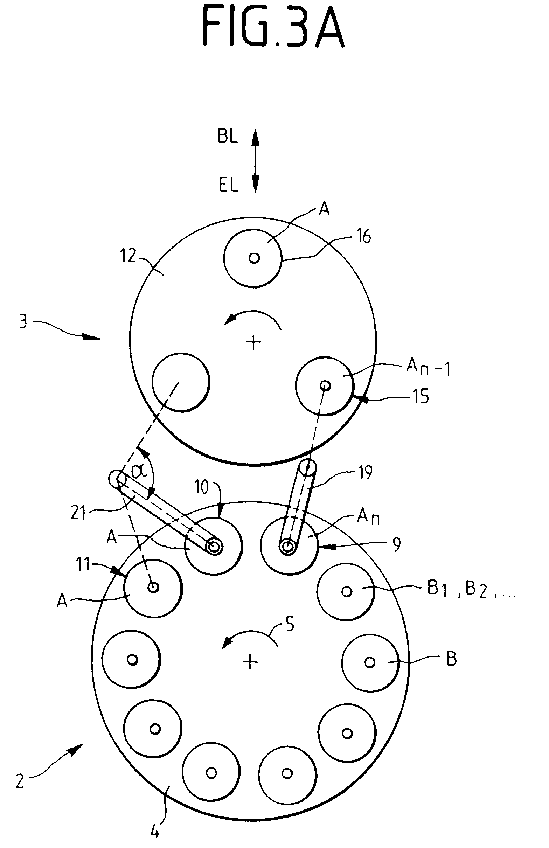

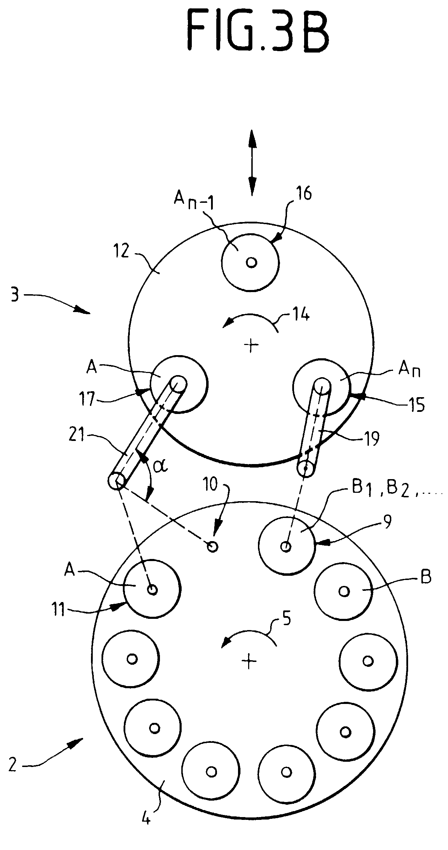

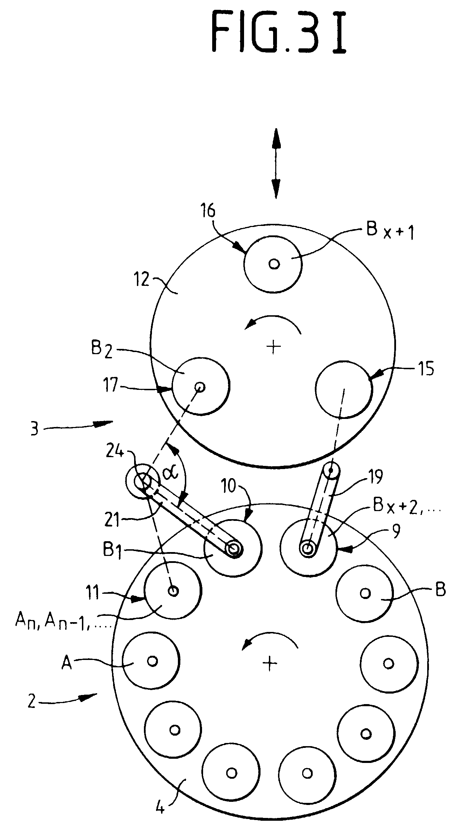

Der Weg unterschiedlicher Substrate des Typs A und B durch die Be- und Entladevorrichtung, sowie die dabei notwendigen Bewegungen der Transportarme 19 und 21 ist in den folgenden Figuren 3A bis 3I schrittweise dargestellt. Die Kennzeichnung der Substrate ist hier, im Gegensatz zu den Figuren 1 und 2 alpha-numerisch ausgeführt, um den Wechsel der Substrate vom Typ A zum Typ B innerhalb der Vorrichtung klarer darzustellen. Dabei gibt der Index, welcher sich hinter dem Buchstaben befindet, die Zählnummer des Substrats des jeweiligen Typs an, wobei diese bei 1,2,3 ... beginnt, sich mit x, x+1, ... fortsetzt, und bei n-1, n endet. Die Richtung der Pfeile BL sowie EL geben jeweils die Be- und Entladerichtung der Beschichtungsanlage an.

Das letzte Substrat An (Figur 3A) des Typs A befindet sich auf der Beladestation 9 des Drehtellers 4, das vorletzte Substrat Aₙ₋₁ befindet sich auf der Beladestation 15 des Drehtellers 12. Auf allen weiteren in Bewegungsrichtung der Substrate nachfolgenden Stationen 16, 10, 11 befinden sich ebenfalls noch Substrate des Typs A. Auf den Haltedornen, welche sich in Drehrichtung 5 vor der Beladestation 9 des Magazins 2 befinden sind nun Substrate des Typs B gestapelt.

Nachdem das letzte Substrat An vom Magazin 2 entnommen ist (Figur 3B) sind beide Drehteller 4, 12 schrittweise um eine Position weiter gedreht worden. Der Haltedorn, von dem soeben das letzte Substrat Aₙ entnommen wurde, befindet sich nun auf der Entladeposition 10 des Magazins 2. Der Stapel der ersten Substrate des Typs B₁, B₂, ... ist nun auf der Beladeposition 9 des Magazins 2 angekommen. Das letzte Substrat Aₙ befindet sich nun auf der Beladestation 15 der Übergabeeinrichtung 3. Der Transportarm 21 hat bislang alle Substrate über den Schwenkwinkel α bewegt, und auf dem Haltedorn abgelegt, welcher sich bislang auf der Entladeposition 10 des Magazins 2 befand. Dieser Haltedorn befindet sich nun auf der Entladeposition 11.

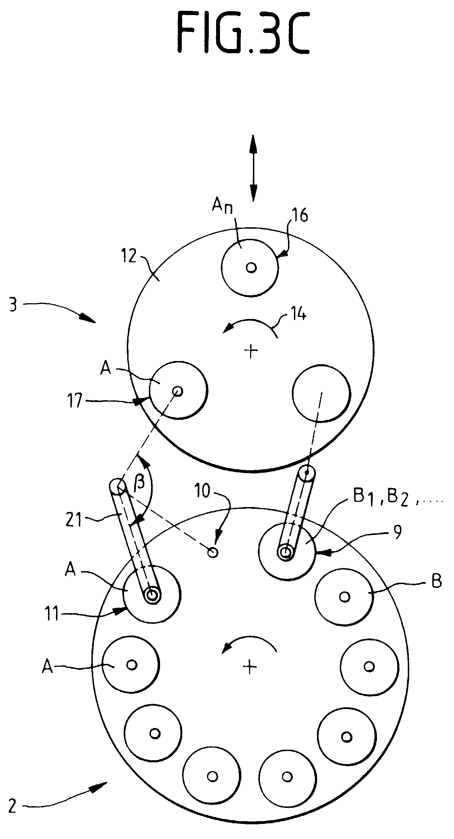

Die nächste Schwenkbewegung des Transportarms 21 (Figur 3C) erstreckt sich nun über den Schwenkwinkel β, so daß alle weiteren Substrate des Typs A auf der Entlade-Station 11 des Magazins 2 gestapelt werden. Nach einer weiteren schrittweisen Drehung des Drehtellers 12 in Drehrichtung 14 befindet sich nun das letzte Substrat Aₙ auf der Übergabestation 16 der Übergabeeinrichtung 3.

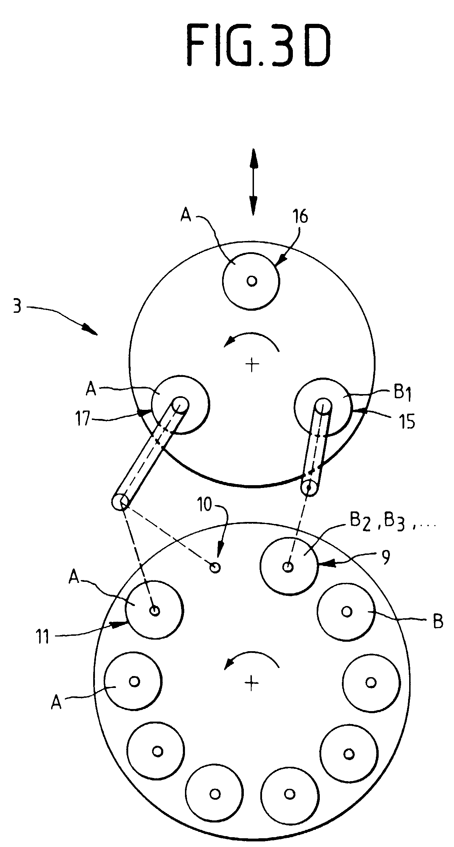

Im nächsten Schritt (Figur 3D) wird das erste Substrat B₁ des Typs B auf der Belade-Station 15 der Übergabeeinrichtung 3 abgelegt.

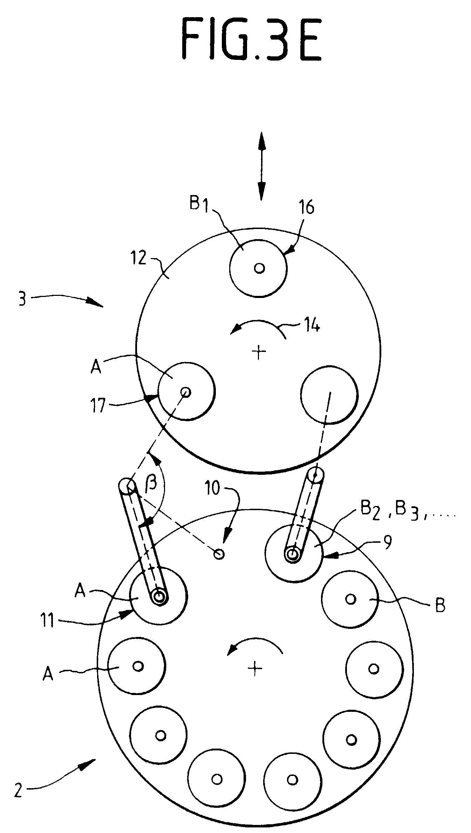

Nach einer weiteren schrittweisen Drehung (Figur 3E) befindet sich das Substrat B₁ auf der Übergabestation 16 der Übergabeeinrichtung 3. Weitere Substrate des Typs A werden von der Entladestation 17 der Übergabeeinrichtung 3 über den Schwenkwinkel β zur Entladestation 11 des Magazins 2 transportiert.

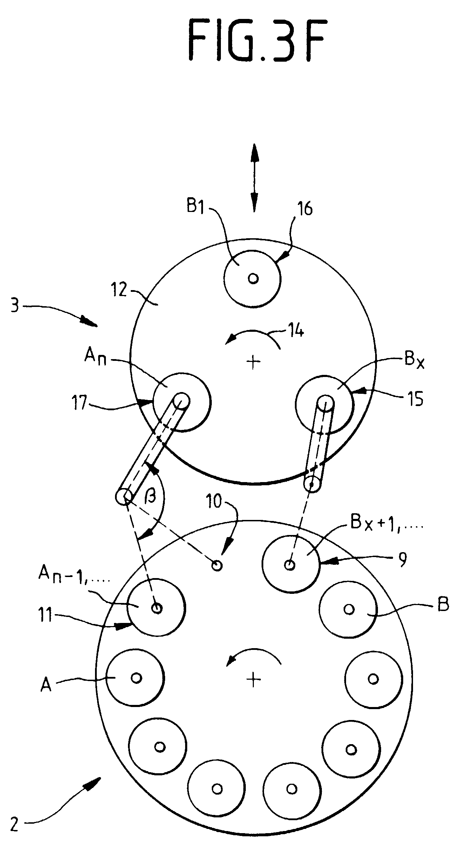

Nachdem das Substrat B₁ (Figur 3F) aus der Beschichtungsanlage zurückgekehrt ist, wird dieses wieder auf der Übergabestation 16 des Drehtellers 12 abgelegt. Ein nachfolgendes Substrat Bₓ befindet sich inzwischen auf der Beladestation 15, während das letzte Substrat Aₙ des Typs A auf der Entladestation 17 der Übergabeeinrichtung 3 angekommen ist. Auf dem Substratstapel, welcher sich auf der Entladestation 11 des Magazins 2 befindet, liegt nun das vorletzte Substrat Aₙ₋₁ oben auf.

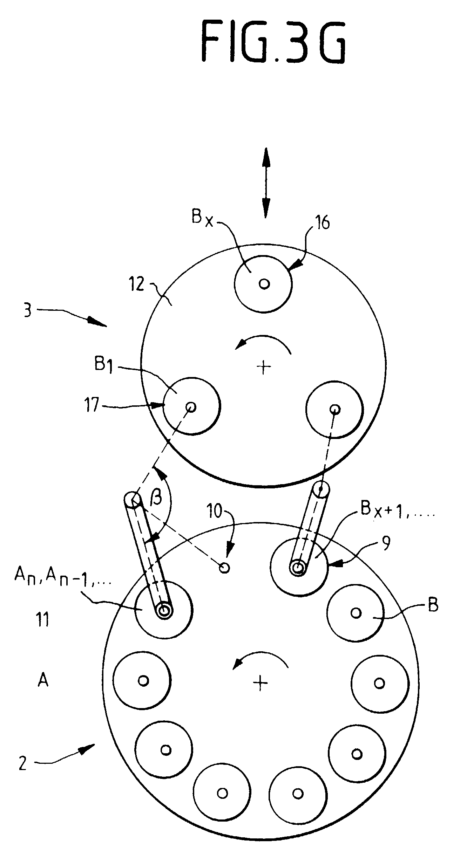

Das letzte Substrat Aₙ (Figur 3G) wird nun noch über den Schwenkwinkel β zur Entladestation 11 des Magazins 2 zurückgeführt. Das erste Substrat B₁ ist nun auf der Entlade-Station 17 der Übergabeeinrichtung 3 angekommen, so daß sich auf allen Stationen des Drehtellers 12 und auf den in Transportrichtung davor angeordneten Stationen Substrate des Typs B befinden.

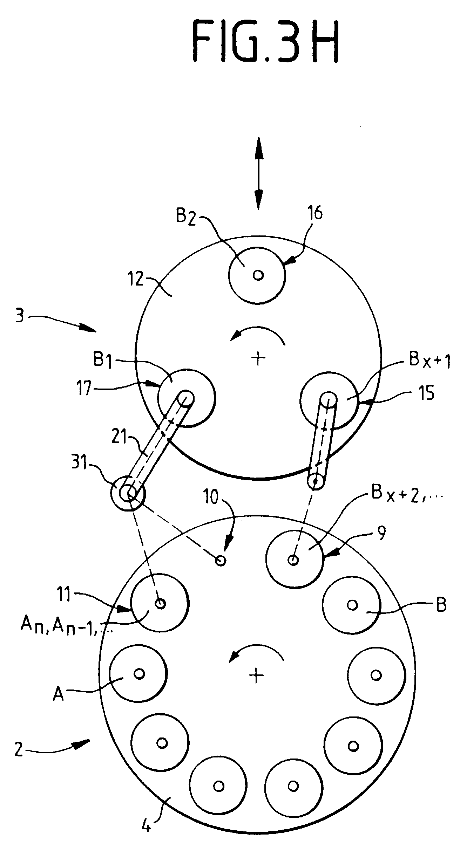

In Figur 3H ist die Position des Drehtellers 4 des Magazins 2 gegenüber der Darstellung in 3B noch immer unverändert, so daß der Haltedorn, welcher sich auf der Entladestation 10 befindet auch noch leer ist. Der Drehteller 12 der Übergabeeinrichtung 3 dagegen ist inzwischen um mehrere Stationen weiter gedreht worden. Nachdem der Transportarm 21 das erste Substrat B₁ vom Typ B aufgenommen hat, erhält der Stellmotor 31 ein erneutes Signal von dem Zählwerk.

Während der Transportarm 19 (Figur 3I) schrittweise ein Substrat des Typs B nach dem anderen von der Belade-Station 9 des Magazins 2 zur Belade-Station 15 der Übergabeeinrichtung 3 nachführt, führt der Transportarm 21 das erste Substrat B₁ des Typs B zur Entladestation 10 des Magazins 2 zurück. Hierbei überstreicht der Entladearm 21 wieder den Schwenkwinkel a. Somit befinden sich auf der Entladestation 11 des Magazins 2 und allen in Transportrichtung nachfolgenden Haltedornen Substrate des Typs A. Auf der Entladestation 10 des Magazins 2 und allen in Transportrichtung vor dieser Station angeordneten Haltedornen befinden sich nun Substrate des Typs B. Damit ist eine klare Trennung der Substrate des Typs A, bzw. B auf dem Drehteller 4 des Magazins 2 auch nach der Beschichtung der unterschiedlichen Substrate A und B sichergestellt.

### Auflistung der Einzelteile

- 1: Beschichtungsanlage
- 2: Magazin
- 3: Übergabeeinrichtung
- 4: Drehteller
- 5: Drehrichtung
- 6, 6', 6", ...: Haltedorn
- 7, 7',7", ...: Substrat
- 8: Rotationsachse
- 9: Belade-Station
- 10: Entlade-Station
- 11: Entlade-Station
- 12: Drehteller
- 13: Rotationsachse
- 14: Drehrichtung
- 15: Belade-Station
- 16: Übergabe-Station
- 17: Entlade-Station
- 18, 18', ...: Substrat
- 19: Belade-, Transportarm
- 20: Übergabe-, Transportarm
- 21: Entlade-, Transportarm
- 22, 23, 24: Schwenkachse
- 25, 26, 27: Schwenkbewegung
- 28: Substrat
- 29: Sensor
- 30: Zählwerk
- 31: Stellmotor
- 32: Steuerkabel
- 33: Steuereinrichtung
- α: Schwenkwinkel
- β: Schwenkwinkel
- BL: Beladerichtung
- EL: Entladerichtung
- A, Aₙ, Aₙ₋₁ ...: Substrat Typ A
- B, B₁, Bₓ, Bₓ₊₁, ...: Substrat Typ B

## Patentansprüche

1. Vorrichtung zum schrittweisen und automatischen Be- und Entladen einer Beschichtungsanlage (1) mit scheibenförmigen Substraten, insbesondere für die Datenspeichertechnik, im wesentlichen bestehend aus
- einem Magazin (2) mit einem ersten Drehteller (4), welcher schrittweise um eine ortsfeste Rotationsachse drehbar ist und einer Vielzahl in äquidistanter Verteilung und in Kreisform auf dem Drehteller (4) angeordneten Haltedornen (6, 6', ...), wobei auf jedem Dorn (6, 6', ...) mehrere Substrate (7, 7', ...) stapelbar sind und für das Magazin (2) ortsfeste Belade-(9) und Entlade-Stationen (10, 11) vorgesehen sind und der Abstand zwischen je zwei benachbarten Stationen (9, 10, 11) dem Abstand zwischen je zwei benachbarten Haltedornen (6, 6', ..) entspricht,
- einer Übergabeeinrichtung (3) mit einem zweiten Drehteller (12), der schrittweise um eine ortsfeste Rotationsachse (13) drehbar ist und der mindestens drei Stationen - eine Belade- (15), eine Übergabe- (16) und eine Entlade-Station (17) - zur Aufnahme je eines Substrates (18, 18', ...) aufweist, mit mindestens drei Transportarmen (19, 20, 21), einem Belade- (19), einem Übergabe- (20) und einem Entladearm (21), welche mit je einer Station des zweiten Drehtellers (12) korrespondieren, wobei der Beladearm (19) jeweils ein Substrat (7, 7', ...) von dem Dorn (6, 6', ...) aufnimmt, welcher sich gerade auf der Beladestation (9) des Magazins (2) befindet und das Substrat (7, 7', ...) auf der Beladestation (15) der Übergabeeinrichtung (3) ablegt und der Entladearm (21) gleichzeitig ein Substrat (18, 18', ...) von der Entladestation (17) der Übergabeeinrichtung (3) aufnimmt und dieses auf einen von zwei möglichen Haltedornen (6, 6', ...) zurücklegt, welche sich gerade auf den beiden Entladestationen (10, 11) des Magazins (2) befinden und
- einer Steuereinrichtung (33), welche insbesondere aus einem Sensor (29), einem Zählwerk (30) und einem Stellmotor (31) besteht, wobei der Stellmotor (31) den Entladearm (21) antreibt und der zu beladende Dorn (6, 6', ...) des Magazins (2) durch die Steuereinrichtung (33) vorherbestimmbar ist.

2. Vorrichtung nach Anspruch 1, **dadurch gekennzeichnet**, daß die Drehteller (4, 12) in einer horizontalen Ebene angeordnet sind.

3. Vorrichtung nach Anspruch 2, **dadurch gekennzeichnet**, daß die Haltedorne (6, 6', ...) senkrecht auf dem Drehteller (12) angeordnet sind.

4. Vorrichtung nach Anspruch 3, **dadurch gekennzeichnet**, daß die Substrate (7, 7', ..., 18, 18', ..., 28) eine zentrische Haltebohrung aufweisen.

5. Vorrichtung nach Anspruch 1, **dadurch gekennzeichnet**, daß die Drehteller (4, 12) nur in einer Drehrichtung (5, 14) jeweils um eine Station schrittweise weiter bewegbar sind.

6. Vorrichtung nach Anspruch 1, **dadurch gekennzeichnet**, daß die Transportarme (19, 20, 21) je eine ortsfeste Schwenkachse (22, 23, 24) haben.

7. Vorrichtung nach Anspruch 6, **dadurch gekennzeichnet**, daß an den Transportarmen (19, 20, 21) Mittel vorgesehen sind, die die Substrate (7, 7', ..., 18, 18', ..., 28) greifen, heben, schwenken oder wenden, senken und ablegen.

8. Vorrichtung nach Anspruch 7, **dadurch gekennzeichnet**, daß eine Schwenkbewegung des Belade- (19) und des Übergabearms (20) durch je zwei ortsfeste Endpunkte markiert ist.

9. Vorrichtung nach Anspruch 7, **dadurch gekennzeichnet**, daß die Schwenkachse des Entladearms (21) so angeordnet ist, damit dieser mit seinem beweglichen Ende drei ortsfeste Endpunkt auf den beiden Drehtellern (4, 12) erreicht.

10. Vorrichtung nach den Ansprüchen 8 und 9, **dadurch gekennzeichnet**, daß der Entladearm (21) einen Schwenkwinkel (α) zwischen Entladestation (17) der Übergabeeinrichtung (3) und der einen Entladestation(10) des Magazins (2) überstreicht.

11. Vorrichtung nach den Ansprüchen 8 bis 10, **dadurch gekennzeichnet**, daß der Entladearm (21) einen Schwenkwinkel (β) zwischen Entladestation (17) der Übergabeeinrichtung (3) und der anderen Entladestation (11) des Magazins (2) überstreicht und daß der Schwenkwinkel (β) größer ist als der Schwenkwinkel (α).

12. Vorrichtung nach Anspruch 1, **dadurch gekennzeichnet**, daß auf einem Haltedorn (6, 6', ...) des Magazins (2) nur gleichartige Substrate (7, 7', ...) gestapelt sind.

13. Vorrichtung nach Anspruch 12, **dadurch gekennzeichnet**, daß auf verschiedenen Haltedornen (6, 6', ...) des Magazins (2) verschiedenartige Substrate (7, 7', ...) gestapelt sind.

14. Vorrichtung nach den Ansprüchen 8 bis 10, **dadurch gekennzeichnet**, daß die Anzahl der Schwenkbewegungen des Entladearms (21) mit dem Schwenkwinkel (β) in einem Zählwerk (30) speicherbar sind.

15. Vorrichtung nach Anspruch 14, **dadurch gekennzeichnet**, daß, nachdem der Stellmotor (31) das zweite elektrische Signal erhalten hat, der Entladearm (21) den Schwenkwinkel (a) überstreicht und die folgenden Substrate (18, 18',...) auf dem Dorn (6, 6', ...) ablegt, welcher sich gerade auf der anderen Entladestation (10) des Magazins (2) befindet.

16. Vorrichtung nach Anspruch 15, **dadurch gekennzeichnet**, daß der Entladearm (21) bis zum Erhalt eines dritten elektrischen Signals den Schwenkwinkel (α) überstreicht.

17. Vorrichtung nach Anspruch 16, **dadurch gekennzeichnet**, daß der Stellmotor (31) ein drittes elektrisches Signal erhält, nachdem alle Substrate (7, 7', ...) von dem Dorn (6, 6', ...) entnommen sind, der sich nun auf der Beladestation (9) des Magazins (2) befindet.

18. Vorrichtung nach Anspruch 1, **dadurch gekennzeichnet**, daß der Übergabearm (20) je ein Substrat (18, 18', ..., 28) von der Übergabestation (16) der Übergabeeinrichtung (3) zur Beschichtungsanlage (1) und zurück transportiert.

19. Verfahren zum schrittweisen und automatischen Be- und Entladen einer Beschichtungsanlage (1) mit scheibenförmigen Substraten, insbesondere für die Datenspeichertechnik, mittels einer Vorrichtung, im wesentlichen bestehend aus
- einem Magazin (2) mit einem ersten Drehteller (4), welcher schrittweise um eine ortsfeste Rotationsachse drehbar ist und einer Vielzahl in äquidistanter Verteilung und in Kreisform auf dem Drehteller (4) angeordneten Haltedornen (6, 6', ...), wobei auf jedem Dorn (6, 6', ...) mehrere Substrate (7, 7', ...) stapelbar sind und für das Magazin (2) ortsfeste Belade-(9) und Entlade-Stationen (10, 11) vorgesehen sind und der Abstand zwischen je zwei benachbarten Stationen (9, 10, 11) dem Abstand zwischen je zwei benachbarten Haltedornen (6, 6', ..) entspricht,
- einer Übergabeeinrichtung (3) mit einem zweiten Drehteller (12), der schrittweise um eine ortsfeste Rotationsachse (13) drehbar ist und der mindestens drei Stationen - eine Belade- (15), eine Übergabe- (16) und eine Entlade-Station (17) - zur Aufnahme je eines Substrates (18, 18', ...) aufweist, mit mindestens drei Transportarmen (19, 20, 21), einem Belade- (19), einem Übergabe- (20) und einem Entladearm (21), welche mit je einer Station des zweiten Drehtellers (12) korrespondieren, wobei der Beladearm (19) jeweils ein Substrat (7, 7', ...) von dem Dorn (6, 6', ...) aufnimmt, welcher sich gerade auf der Beladestation (9) des Magazins (2) befindet und das Substrat (7, 7', ...) auf der Beladestation (15) der Übergabeeinrichtung (3) ablegt und der Entladearm (21) gleichzeitig ein Substrat (18, 18', ...) von der Entladestation (17) der Übergabeeinrichtung (3) aufnimmt und dieses auf einen von zwei möglichen Haltedornen (6, 6', ...) zurücklegt, welche sich gerade auf den beiden Entladestationen (10, 11) des Magazins (2) befinden und
- einer Steuereinrichtung (33), welche insbesondere aus einem Sensor (29), einem Zählwerk (30) und einem Stellmotor (31) besteht, wobei der Stellmotor (31) den Entladearm (21) antreibt und der zu beladende Dorn (6, 6', ...) des Magazins (2) durch die Steuereinrichtung (33) vorherbestimmbar ist.

## Claims

1. Apparatus for progressively and automatically loading and unloading a coating installation (1) with disc-shaped substrates, in particular for data storage technology, substantially comprising
- a magazine (2) having a first rotary table (4), which is progressively rotatable about a fixed axis of rotation, and a plurality of holding mandrels (6, 6', ...) which are arranged equidistantly distributed in the shape of a circle on the rotary table (4), a plurality of substrates (7, 7', ...) being stackable on each mandrel (6, 6', ...) and stationary loading (9) and unloading stations (10, 11) being provided for the magazine (2) and the distance between each two adjacent stations (9, 10, 11) corresponding to the distance between each two adjacent holding mandrels (6, 6', ...),
- a transfer device (3) having a second rotary table (12), which is progressively rotatable about a fixed axis of rotation (13) and has at least three stations - a loading station (15), a transfer station (16) and an unloading station (17) - for receiving in each case one substrate (18, 18', ...), having at least three transport arms (19, 20, 21) - a loading arm (19), a transfer arm (20) and an unloading arm (21) - which correspond each with one station of the second rotary table (12), the loading arm (19) picking up in each case one substrate (7, 7', ...) from the mandrel (6, 6', ...) situated at that moment at the loading station (9) of the magazine (2) and depositing the substrate (7, 7', ...) at the loading station (15) of the transfer device (3) and the unloading arm (21) at the same time picking up a substrate (18, 18', ...) from the unloading station (17) of the transfer device (3) and placing it back onto one of two possible holding mandrels (6, 6', ...) situated at that moment at the two unloading stations (10, 11) of the magazine (2), and
- a control device (33), which in particular comprises a sensor (29), a counting mechanism (30) and a servomotor (31), wherein the servomotor (31) drives the unloading arm (21) and the mandrel (6, 6', ...) of the magazine (2) which is to be loaded is predeterminable by the control device (33).

2. Apparatus according to claim 1, **characterized in** that the rotary tables (4, 12) are disposed in a horizontal plane.

3. Apparatus according to claim 2, **characterized in** that the holding mandrels (6, 6', ...) are disposed vertically on the rotary table (12).

4. Apparatus according to claim 3, **characterized in** that the substrates (7, 7', ..., 18, 18', ..., 28) have a centrical location hole.

5. Apparatus according to claim 1, **characterized in** that the rotary tables (4, 12) are progressively movable by one station at a time in one direction of rotation (5, 14) only.

6. Apparatus according to claim 1, **characterized in** that the transport arms (19, 20, 21) each have a fixed swivelling axis (22, 23, 24).

7. Apparatus according to claim 6, **characterized in** that provided on the transport arms (19, 20, 21) are means of gripping, lifting, swivelling or turning, lowering and depositing the substrates (7, 7', ..., 18, 18', ..., 28).

8. Apparatus according to claim 7, **characterized in** that a swivelling motion of the loading arm (19) and of the transfer arm (20) is marked by, in each case, two stationary end points.

9. Apparatus according to claim 7, **characterized in** that the swivelling axis of the unloading arm (21) is so disposed that the movable end of said unloading arm reaches three stationary end points on the two rotary tables (4, 12).

10. Apparatus according to claims 8 and 9, **characterized in** that the unloading arm (21) swings through a swivel angle (a) between unloading station (17) of the transfer device (3) and the one unloading station (10) of the magazine (2).

11. Apparatus according to claims 8 to 10, **characterized in** that the unloading arm (21) swings through a swivel angle (β) between unloading station (17) of the transfer device (3) and the other unloading station (11) of the magazine (2) and that the swivel angle (β) is greater than the swivel angle (α).

12. Apparatus according to claim 1, **characterized in** that only substrates (7, 7', ...) of an identical type are stacked on a holding mandrel (6, 6', ...) of the magazine (2).

13. Apparatus according to claim 12, **characterized in** that substrates (7, 7', ...) of different types are stacked on different holding mandrels (6, 6', ...) of the magazine (2).

14. Apparatus according to claims 8 to 10, **characterized in** that the number of swivelling motions of the unloading arm (21) through the swivel angle (β) are storable in a counting mechanism (30).

15. Apparatus according to claim 14, **characterized in** that, after the servomotor (31) has received the second electrical signal, the unloading arm (21) swings through the swivel angle (α) and deposits the following substrates (18, 18', ...) on the mandrel (6, 6', ...) situated at that moment at the other unloading station (10) of the magazine (2).

16. Apparatus according to claim 15, **characterized in** that the unloading arm (21) up to receiving a third electrical signal swings through the swivel angle (α).

17. Apparatus according to claim 16, **characterized in** that the servomotor (31) receives a third electrical signal after all of the substrates (7, 7', ...) have been removed from the mandrel (6, 6', ...) which is then situated at the loading station (9) of the magazine (2).

18. Apparatus according to claim 1, **characterized in** that the transfer arm (20) transports in each case one substrate (18, 18', ..., 28) from the transfer station (16) of the transfer device (3) to the coating installation (1) and back.

19. Method of progressively and automatically loading and unloading a coating installation (1) with disc-shaped substrates, in particular for data storage technology, by means of an apparatus substantially comprising
- a magazine (2) having a first rotary table (4), which is progressively rotatable about a fixed axis of rotation, and a plurality of holding mandrels (6, 6', ...) which are arranged equidistantly distributed in the shape of a circle on the rotary table (4), a plurality of substrates (7, 7', ...) being stackable on each mandrel (6, 6', ...) and stationary loading (9) and unloading stations (10, 11) being provided for the magazine (2) and the distance between each two adjacent stations (9, 10, 11) corresponding to the distance between each two adjacent holding mandrels (6, 6', ...),
- a transfer device (3) having a second rotary table (12), which is progressively rotatable about a fixed axis of rotation (13) and has at least three stations - a loading station (15), a transfer station (16) and an unloading station (17) - for receiving in each case one substrate (18, 18', ...), having at least three transport arms (19, 20, 21) - a loading arm (19), a transfer arm (20) and an unloading arm (21) - which correspond each with one station of the second rotary table (12), the loading arm (19) picking up in each case one substrate (7, 7', ...) from the mandrel (6, 6', ...) situated at that moment at the loading station (9) of the magazine (2) and depositing the substrate (7, 7', ...) at the loading station (15) of the transfer device (3) and the unloading arm (21) at the same time picking up a substrate (18, 18', ...) from the unloading station (17) of the transfer device (3) and placing it back onto one of two possible holding mandrels (6, 6', ...) situated at that moment at the two unloading stations (10, 11) of the magazine (2), and
- a control device (33), which in particular comprises a sensor (29), a counting mechanism (30) and a servomotor (31), wherein the servomotor (31) drives the unloading arm (21) and the mandrel (6, 6', ...) of the magazine (2) which is to be loaded is predeterminable by the control device (33).

## Revendications

1. Appareil pour charger et décharger, automatiquement et par indexage successif, une installation de revêtement (1) avec des substrats en forme de disque, en particulier pour la technique de mémorisation des données, essentiellement constitué de:
- Un magasin (2) comportant un premier plateau rotatif (4), qui peut être entraîné en rotation, par indexage successif, autour d'un axe de rotation fixe en position, ainsi qu'une pluralité de broches de stockage (6, 6', ...) disposées sur le plateau rotatif (4) en répartition équidistante en forme de cercle, dans le cas duquel plusieurs substrats (7, 7', ...) peuvent être empilés sur chaque broche (6, 6', ...) et des stations de chargement (9) et de déchargement (10, 11) sont prévues sur le magasin (2) et la distance entre chacune de deux stations voisines (9, 10, 11) correspond à la distance entre chacune de deux broches de stockage voisines (6, 6', ...),
- un dispositif de transfert (3) comportant un second plateau rotatif (12) qui peut être entraîné en rotation par indexage successif autour d'un axe de rotation (33) fixe en position et présente au moins trois stations - une station de chargement (15), une station de transfert (16) et une station de déchargement (17) - pour recevoir, chacune, un substrat (18, 18', ...), comportant au moins trois bras de transport (19, 20, 21), un bras de chargement (19), un bras de transfert (20) et un bras de déchargement (21), dont chacun correspond à une station du second plateau rotatif (12), étant précisé que le bras de chargement (19) reçoit chaque fois un substrat (7, 7', ...) en provenance de la broche (6, 6', ...) qui se trouve justement sur la station de chargement (9) du magasin (2) et dépose le substrat (7, 7', ...) sur la station de chargement (15) du dispositif de transfert (3) et que le bras de déchargement (21) reçoit simultanément un substrat (18, 18', ...) en provenance de la station de déchargement (17) et le redépose sur l'une de deux broches de stockage possibles (6, 6', ...) qui se trouvent justement sur les deux stations de déchargement (10, 11) du magasin (2) et
- un dispositif de commande (33) qui est en particulier constitué d'un détecteur (29), d'un compteur (30) et d'un moteur réglant (31), le moteur réglant (31) entraînant le bras de déchargement (21) et la broche (6, 6' ...) du magasin (2) qui est à charger pouvant être déterminée à l'avance par le dispositif de commande (33).

2. Appareil selon la revendication 1, **caractérisé par le fait** que les plateaux rotatifs (4, 12) sont disposés dans un plan horizontal.

3. Appareil selon la revendication 2, **caractérisé par le fait** que les broches de stockage (6, 6', ...) sont disposées verticalement sur le plateau rotatif (12).

4. Appareil selon la revendication 3, **caractérisé par le fait** que les substrats (7, 7', ..., 18, 18', ..., 28) présentent un perçage central de stockage.

5. Appareil selon la revendication 1, **caractérisé par le fait** que les plateaux rotatifs (4, 12) ne peuvent continuer à avancer, par indexage successif, que dans un sens de rotation (5, 14), chaque fois d'une station.

6. Appareil selon la revendication 1, **caractérisé par le fait** que les bras de transport (19, 20, 21), ont chacun un axe de pivotement (22, 23, 24) fixe en position.

7. Appareil selon la revendication 6, **caractérisé par le fait** que sur les bras de transport (19, 20, 21) sont prévus des moyens qui saisissent, lèvent, font pivoter ou tourner, abaissent et déposent les substrats (7, 7', ..., 18, 18', ..., 28).

8. Appareil selon la revendication 8, **caractérisé par le fait** qu'un mouvement de pivotement du bras de chargement (19) et du bras de transfert (21) est borné par, chaque fois, deux points terminaux fixes en position.

9. Appareil selon la revendication 7, **caractérisé par le fait** que l'axe de pivotement du bras de déchargement (21) est disposé de façon que, par son extrémité mobile, celui-ci atteigne, sur les deux plateaux rotatifs (4, 12), trois points terminaux fixes en position.

10. Appareil selon les revendications 8 et 9, **caractérisé par le fait** que le bras de déchargement (21) parcourt un angle de pivotement (α) entre la station de déchargement (17) du dispositif de transfert (3) et la première station de déchargement (10) du magasin (2).

11. Appareil selon les revendications 8 à 10, **caractérisé par le fait** que le bras de déchargement (21) parcourt un angle de pivotement (β) entre la station de déchargement (17) du dispositif de transfert (3) et l'autre station de déchargement (11) du magasin (2) et que l'angle de pivotement (β) est supérieur à l'angle de pivotement (a).

12. Appareil selon la revendication 1, **caractérisé par le fait** que sur une broche de stockage (6, 6',...) du magasin (2) ne sont empilés que des substrats identiques (7, 7', ...).

13. Appareil selon la revendication 12, **caractérisé par le fait** que sur différentes broches de stockage (6, 6', ...) du magasin (2) sont empilés des substrats de types différents (7, 7', ...).

14. Appareil selon les revendications 8 à 10, **caractérisé par le fait** que le nombre des mouvements de pivotement du bras de déchargement (21) sur l'angle de pivotement (β) peut être mémorisé dans un compteur (30).

15. Appareil selon la revendication 14, **caractérisé par le fait** qu'après que le moteur réglant (31) a reçu le second signal électrique, le bras de déchargement (21) parcourt l'angle de pivotement (a) et dépose les substrats suivants (18, 18', ...) sur la broche (6, 6', ...) qui se trouve justement sur l'autre station de déchargement (10) du magasin (2).

16. Appareil selon la revendication 15, **caractérisé par le fait** que le bras de déchargement (21) franchit l'angle de pivotement (a) jusqu'à la réception d'un troisième signal électrique.

17. Appareil selon la revendication 16, **caractérisé par le fait** que le moteur réglant (31) reçoit un troisième signal électrique après que tous les substrats (7, 7', ...) ont été prélevés sur la broche (6, 6', ...) qui se trouve actuellement sur la station de chargement (29) du magasin (2).

18. Appareil selon la revendication 1, **caractérisé par le fait** que le bras de transfert (20) transporte chaque fois un substrat (18, 18', ...), de la station de transfert (16) du dispositif de transfert (3), à la station de revêtement (1) et retour.

19. Procédé pour charger et décharger automatiquement et par indexage successif, une installation de revêtement (1) avec des substrats en forme de disque, en particulier pour la technique de mémorisation des données, essentiellement constitué de:
- Un magasin (2) comportant un premier plateau rotatif (4), qui peut être entraîné en rotation, par indexage successif, autour d'un axe de rotation fixe en position, ainsi qu'une pluralité de broches de stockage (6, 6', ...) disposées sur le plateau rotatif (4) en répartition équidistante en forme de cercle, dans le cas duquel plusieurs substrats (7, 7', ...) peuvent être empilés sur chaque broche (6, 6', ...) et des stations de chargement (9) et de déchargement (10, 11) sont prévues sur le magasin (2) et la distance entre chacune de deux stations voisines (9, 10, 11) correspond à la distance entre chacune de deux broches de stockage voisines (6, 6', ...),
- un dispositif de transfert (3) comportant un second plateau rotatif (12) qui peut être entraîné en rotation par indexage successif autour d'un axe de rotation (33) fixe en position et présente au moins trois stations - une station de chargement (15), une station de transfert (16) et une station de déchargement (17) - pour recevoir, chacune, un substrat (18, 18', ...), comportant au moins trois bras de transport (19, 20, 21), un bras de chargement (19), un bras de transfert (20) et un bras de déchargement (21), dont chacun correspond à une station du second plateau rotatif (12), étant précisé que le bras de chargement (19) reçoit chaque fois un substrat (7, 7', ...) en provenance de la broche (6, 6', ...) qui se trouve justement sur la station de chargement (9) du magasin (2) et dépose le substrat (7, 7', ...) sur la station de chargement (15) du dispositif de transfert (3) et que le bras de déchargement (21) reçoit simultanément un substrat (18, 18', ...) en provenance de la station de déchargement (17) et le redépose sur l'une de deux broches de stockage possibles (6, 6', ...) qui se trouvent justement sur les deux stations de déchargement (10, 11) du magasin (2) et
- un dispositif de commande (33) qui est en particulier constitué d'un détecteur (29), d'un compteur (30) et d'un moteur réglant (31), le moteur réglant (31) entraînant le bras de déchargement (21) et la broche (6, 6' ...) du magasin (2) qui est à charger pouvant être déterminée à l'avance par le dispositif de commande (33).
